**Europäisches Patentamt**

**European Patent Office**

**Office européen des brevets**

(11) Publication number: **0 201 954**
**B1**

(12) **EUROPEAN PATENT SPECIFICATION**

(45) Date of publication of patent specification: **27.06.90**

(21) Application number: **86200648.3**

(22) Date of filing: **16.04.86**

(51) Int. Cl.⁵: **H 01 L 23/36,** **H 01 L 23/48**

(54) Semiconductor device comprising a heat sink.

(30) Priority: **22.04.85 NL 8501153**

(43) Date of publication of application:
**20.11.86 Bulletin 86/47**

(45) Publication of the grant of the patent:
**27.06.90 Bulletin 90/26**

(84) Designated Contracting States:
**DE FR GB IT NL**

(56) References cited:
**DE-A-2 027 945**
**FR-A-2 118 101**
**US-A-4 349 585**
**US-A-4 424 527**

**SOLID-STATE AND ELECTRONIC DEVICES, vol.
3, no. 6, November 1979, pages 206-209; R.G.
PLUMB et al.: "Thermal-impedance ageing
characteristics of c.w. stripe lasers"**

(73) Proprietor: **N.V. Philips' Gloeilampenfabrieken
Groenewoudseweg 1
NL-5621 BA Eindhoven (NL)**

(72) Inventor: **Camerling, Erich Robert
c/o INT. OCTROOIBUREAU B.V. Prof. Holstlaan 6
NL-5656 AA Eindhoven (NL)**
Inventor: **Van de Pas, Hermanus Antonius
c/o INT. OCTROOIBUREAU B.V. Prof. Holstlaan 6
NL-5656 AA Eindhoven (NL)**

(74) Representative: **Houbiers, Ernest Emile Marie
Gerlach et al
INTERNATIONAAL OCTROOIBUREAU B.V. Prof.
Holstlaan 6
NL-5656 AA Eindhoven (NL)**

Courier Press, Leamington Spa, England.

## Description

The invention relates to a semiconductor device comprising a semiconductor element which is secured by means of indium solder on a heat-dissipating support of copper or a copper alloy, a barrier layer being formed between the support and the indium solder.

Indium solder has the advantage that the melting temperature is comparatively low. It is used, for example, for soldering semiconductor laser elements. The semiconductor laser elements are not allowed to reach a high temperature; the support, which has to ensure a good heat dissipation, is chosen to be made mostly of copper. However, indium diffused into copper so that a barrier layer has to be formed between the support and the solder. It is known to use a barrier layer of molybdenum. However molybdenum cannot readily be provided and the cost price of molybdenum is high. Platinum is also suggested to be used as a barrier layer. However, platinum has the same disadvantages as molybdenum.

From DE—A—2027945 there is further known a semiconductor device comprising a semiconductor element which is secured by means of solder on a heat dissipating support of copper or a copper alloy, a barrier layer being provided between the support and the solder, said barrier layer consisting of a cobalt layer coated with a gold layer, the cobalt layer having a thickness between 0.2 and 2 µm and the gold layer having a thickness lying between 1 to 2 µm.

The invention has for its object to provide a semiconductor device of the kind mentioned in the opening paragraph, which has a barrier layer which acts effectively, can be provided in a simple manner and is inexpensive. It is a surprise to find that a very effective barrier between indium and a support of copper or a copper alloy is obtained if the barrier layer consists of a cobalt layer coated with a very thin gold layer. The cobalt layer prevents the diffusion of indium into the copper of the support, while the thin gold layer ensures a good wetting during soldering.

According to the invention as claimed, the cobalt layer has a thickness of at least 2 µm and the gold layer has a thickness lying beween 0.05µm and 0.1µm.

According to a further embodiment of the invention, the cobalt layer and the gold layer are applied by electrodeposition. The fact that the cobalt can be applied by electrodeposition means a considerable simplification in the manufacture with respect to other barrier materials, such as molybdenum.

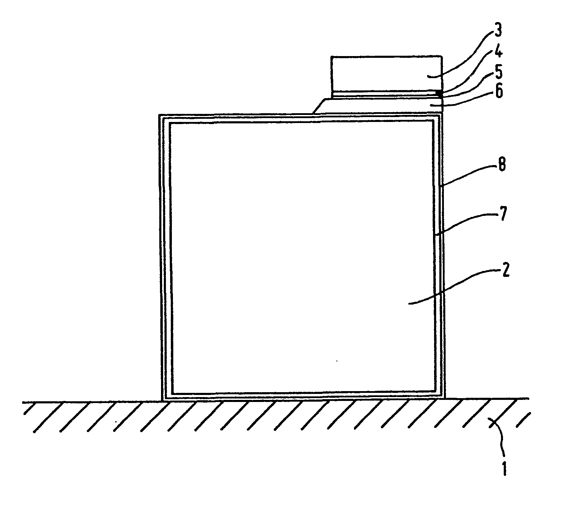

The Figure shows diagrammatically a support with a semiconductor element secured on it, while for the sake of clarity the parts of the Figure are not all drawn to scale.

A support 2 for a semiconductor element 3 is secured on a part 1 of an envelope (not shown) of the semiconductor device. The semiconductor element 3 may be, for example, a semiconductor laser element, which can be composed in known manner of a plurality of layers of gallium arsenide, and gallium aluminium arsenide. For a soldering connection, the major surface to be soldered of such an element is provided, for example, with a molybdenum layer 4, to which a gold layer 5 is applied.

The support is made of copper or of a copper alloy. A good dissipation of the heat developed in the laser element 3 is then ensured. The semiconductor laser element is secured to the support by indium solder 6. The use of the indium has the advantage that the melting temperature during soldering may be comparatively low, i.e. of the order of 160°C to 200°C, depending upon the composition. However, indium solder tends to diffuse into copper. In order to avoid the soldering layer disappearing entirely in the copper, a barrier layer has to be provided.

It is a surprise to find that a layer of cobalt forms a particularly suitable barrier against diffusion of indium into copper. A cobalt layer 7 is applied to the support 2 and a very thin gold layer 8 is applied to the cobalt layer 7. The gold layer 8 ensures a good wetting during soldering. The layers 7 and 8 can be advantageously applied by electrodeposition; they can be present over the whole surface of the support. It is already sufficient when the layers 7 and 8 are present only at the area of the indium solder. However the process of applying the layers thus becomes more complicated. It will be appreciated that the layers 7 and 8 may also be deposited in a different manner, for example by vapour deposition. However, this process is generally more laborious than electrodeposition. It is recommendable, at any rate if the barrier layer is applied only locally to the support, to first apply to the support a thin layer of nickel or nickel phosphorus in order to prevent oxidation of the copper.

Experiments have shown that a barrier layer having a thickness of the cobalt layer of 2 µm or more and of the gold layer of 0.05 to 0.1 µm yields particularly favourable results.

## Claims

1. A semiconductor device comprising a semiconductor element which is secured by means of indium solder on a heat-dissipating support of copper or a copper alloy, a barrier layer being provided between the support and the indium solder, the barrier layer consisting of a cobalt layer coated with a gold layer, the cobalt layer having a thickness of at least 2µm and the gold layer having a thickness lying between 0.05 µm and 0.1 µm.

2. A semiconductor device as claimed in Claim 1, characterized in that the cobalt layer and the gold layer are applied by electrodeposition.

## Patentansprüche

1. Halbleiteranordnung mit einem Halbleiterelement, das mit Hilfe von Indiumlot auf einem wärmeabsorbierenden Träger aus Kupfer oder einer Kupferlegierung befestigt wird, wobei zwischen dem Träger und dem Indiumlot eine Sperrschicht vorgesehen wird, die aus einer mit einer Goldschicht bedeckten Kobaltschicht besteht, wobei die Kobaltschicht eine Dicke von wenigstens 2 µm und die Goldschicht eine Dicke zwischen 0,05 µm und 0,1 µm hat.

2. Halbleiteranordnung nach Anspruch 1, dadurch gekennzeichnet, daß die Kobaltschicht und die Goldschicht durch elektrolytische Abscheidung angebracht werden.

**Revendications**

1. Dispositif semiconducteur comportant un élément semiconducteur fixé par une soudure à l'indium sur un support dissipateur de chaleur en cuivre ou en alliage à base de cuivre, une couche de barrière étant formée entre le support et la soudure à l'indium, la couche de barrière étant constituèe par une couche de cobalt recouverte d'une couche d'or, la couche de cobalt ayant une épaisseur d'au moins 2 µm et la couche d'or une épàisseur comprise entre 0,05 µm et 0,1 µm.

2. Dispositif semiconducteur selon la revendication 1, caractérisé en ce que la couche de cobalt et la couche d'or sont formées par dépôt électrolytique.

EP 0 201 954 B1